# EUROPEAN PATENT SPECIFICATION

(11) **EP 4 545 981 B1**
(45) Date of publication and mention of the grant of the patent: **09.12.2026**
(21) Application number: 24207699.0
(22) Date of filing: 21.10.2024
(51) Int. Cl.: G01R 27/26, G01R 31/28, G01R 31/66, G01R 31/71

(54) **SYSTEMS AND METHODS FOR TESTING ELECTRICAL CONNECTIONS BETWEEN A CHIP AND EXTERNAL CIRCUITRY**
SYSTEME UND VERFAHREN ZUM TESTEN ELEKTRISCHER VERBINDUNGEN ZWISCHEN EINEM CHIP UND EINER EXTERNEN SCHALTUNG
SYSTÈMES ET PROCÉDÉS DE TEST DE CONNEXIONS ÉLECTRIQUES ENTRE UNE PUCE ET UN CIRCUIT EXTERNE

(30) Priority: 25.10.2023 US 202318494088
(43) Date of publication of application: 30.04.2025
(73) Proprietor: NXP B.V., 5656 AG Eindhoven (NL)
(72) Inventor: Janssen, Erwin Johannes Gerardus, 5656 AG Eindhoven (NL); Saric, Tarik, 5656 AG Eindhoven (NL)
(74) Representative: Schmütz, Christian Klaus Johannes

(56) References cited:
- US-A1- 2020 191 862

## Description

### Field

This disclosure relates generally to electronic circuits, and more specifically, to systems and methods for testing electrical connections between a chip and external circuitry.

### Background

An Integrated Circuit (IC) is a set of electronic circuits fabricated on a piece of semiconductor material (e.g., silicon). With the advent of modern semiconductor manufacturing techniques, an ever-increasing number of miniaturized transistors and other IC components may now be integrated into a single electronic package, chip, or microchip. For example, a modern System-on-Chip (SoC) may include most (or all) components of an entire computer or data processing system.

To communicate with external devices, a chip may have a multitude of electrical connections. An example of such a connection is the solder joint.

The inventors hereof have recognized that the ever-increasing number of electrical connections necessary for the operation of complex chips represents a reliability concern insofar as any such connection can be subject to failures due to manufacturing defect, impact, stress, fatigue, etc.

Prior art document US2020/191862 discloses an IC that uses frequency variations of an internal oscillator to detect bonding wire faults between the IC bonding pads and the lead frame pads.

### Brief Description of the Drawings

The present invention(s) are illustrated by way of example and are not limited by the accompanying figures, in which like references indicate similar elements. Elements in the figures are illustrated for simplicity and clarity and have not necessarily been drawn to scale.
FIG. 1 is a diagram of an example of a system for testing an electrical connection between a chip and an external circuit or device, according to some embodiments.
FIG. 2A is a circuit diagram of an example of a first external circuit or device, according to some embodiments.
FIG. 2B is a circuit diagram of an example of second external circuit or device, according to some embodiments.
FIG. 3 is a flowchart of an example of a method for testing electrical connections between a chip and an external circuit, according to some embodiments.

### Detailed Description

Systems and methods for testing electrical connections are described. In various embodiments, a test circuit may be configured to monitor the integrity of a connection between a chip and an external circuit or device, such as an antenna, another chip, etc.

Generally, an external circuit presents an additional shunt impedance to a chip's output terminal, next to an on-chip shunt capacitance configured to provide electrostatic discharge (ESD) protection. In some implementations, a test circuit may include an RC-oscillator connected to an ESD protection circuit and to a chip's on-chip wiring. In case of a connection failure, the electrical path towards the additional shunt impedance is at least partially opened, thus resulting in a change in the oscillation frequency of the RC-oscillator.

The test circuit may be used in situations when the external circuit behaves as (i) a DC open or (ii) a DC short (to the chip).

For example, if the shunt impedance presented by an external circuit behaves capacitively (as a DC open), the test circuit may be configured to oscillate at a selected test frequency when the connection is proper, intact, suitable, functional, or operational, such that failure or degradation of the connection's integrity would result in a greater oscillating frequency. Conversely, if the shunt impedance of the external circuit behaves as a DC short, an oscillating frequency of 0 Hz would indicate that the connection is proper, and deviation from 0 Hz

In the case of a proper chip connection, the low-frequency impedance at the chip pin is different compared to the case of a connection failure. This allows for relatively low-frequency testing of a pin connection interfacing to a high-frequency load, such as a millimeter wave (mmWave) antenna or launcher. Also, the use of low-frequency testing results in reduced complexity compared to high-frequency testing methods.

Accordingly, in different applications, systems and methods described herein may provide greater accuracy (reducing the probability of measurement error), reduced impact on high-frequency performance (because of the absence of components placed in the high-frequency signal path that would otherwise be necessary to implement conventional detection techniques), and reduced power consumption (low-frequency circuits typically consume less power than high-frequency circuits).

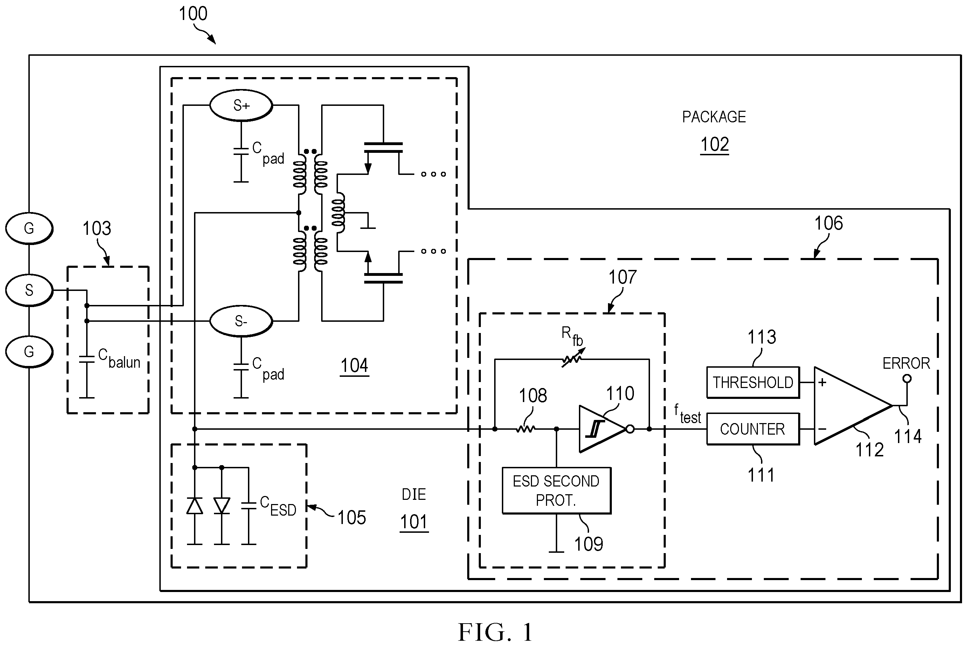

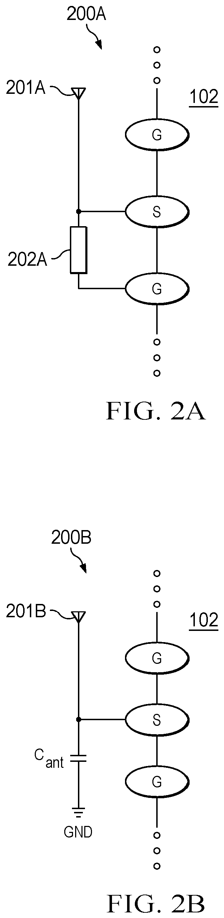

In that regard, FIG. 1 is a diagram of an example of a system for testing an electrical connection between chip 100 and external circuit or device 200A or 200B (FIG. 2). As shown, chip 100 includes semiconductor die 101 encapsulated by electronic package 102.

For simplicity, electronic package 102 includes a signal (S) pad, pin, or terminal, and two ground (G) pads, pins, or terminals. In practical implementations, however, tens or hundreds of pads, pins, or terminals may be present.

In this example, the S pad is coupled to Integrated Circuit (IC) 104 fabricated on semiconductor die 101 via balun circuit 103, which has a single line coupled to two differential lines with parasitic capacitance C_{balun}, as shown. If the main application of chip 101 is a high-frequency RF application (e.g., automotive radar), for instance, IC 104 may include a transformer, matching network, etc. coupled to a Radio Frequency (RF) transceiver.

Semiconductor die 101 also includes ESD protection circuit 105, which has two diodes and parasitic capacitance C_{ESD}, as shown. Test circuit 106 is integrated into to die 101 and coupled to a node between IC 104 and ESD protection circuit 105. In other applications, test circuit 106 may be external to die 101.

Test circuit 106 is coupled to the S pad through 103 and 104. Particularly, test circuit 106 includes relaxation oscillator 107 coupled to counter 111. Relaxation oscillator 107 includes resistor 108 (provide ESD protection together with 109, but not otherwise required) at the input of Schmitt trigger 110. Feedback resistor R_{fb} is coupled between the input and output of Schmitt trigger 110, and second ESD circuit 109 may also be used as shown.

In operation, relaxation oscillator 107 is configured to operate at a test frequency (fₜₑₛₜ) in situations where the connection between chip 101 and an external device coupled to the S pad is proper. In some cases, relaxation oscillator 107 may be configured to oscillate with an fₜₑₛₜ that is one-to-one related to the time constant given by the product of R_{fb} and the total capacitance connected to the S pad.

The oscillating frequency of relaxation oscillator 107 increases, however, when there is a fault or after sufficient degradation in the connection, which is indicated by an impedance or capacitance change at the connection (e.g., because of cracks in a solder joint or the like at the S pad).

Counter 111 increments a value that indicates a number of times Schmitt trigger 110 changes its state for a selected period of time (after which it automatically resets), and therefore stores a value indicative of a frequency of oscillation of relaxation oscillator 107. Counter 111 is coupled to the inverting input of comparator 112.

Threshold register 113 is configured with a frequency threshold value. When the frequency of oscillation of relaxation oscillator 107 overcomes the frequency threshold value, comparator 112 changes the state of error signal 114 (e.g., from "1" to "0"), thereby reporting a connection failure; which in turn may be handled by a safety circuit or process within chip 100.

FIG. 2A is a circuit diagram of an example of external circuit or device 200A. In this example, external circuit or device 200A comprises antenna 201A coupled to the S pad and to a G pad of package 102 via 1/4 wave stub 202A; therefore, it behaves as a DC short. When a solder ball breaks at the S pad, the S pad is no longer shorted to the G pad, producing a non-zero fₜₑₛₜ. In case of a ball break, when the value of counter 111 exceeds the value of threshold register 117, comparator 212 reports a connection failure.

FIG. 2B is a circuit diagram of an example of external circuit or device 200B. In this implementation, external circuit or device 200B comprises antenna 201B coupled to the S pad of package 102 and to parasitic capacitance Cₐₙₜ; therefore it behaves as a DC open. In the event of a solder ball joint break the capacitive load changes, thus producing a corresponding change in fₜₑₛₜ. In case of a ball break, when the value of counter 111 exceeds the value of threshold register 117, comparator 212 reports a connection failure.

If there is a proper connection between chip 100 and antenna 200A, the S pad is shorted to the G pad, which is galvanically connected to the ground (GND) on chip 100. Therefore, the voltage across ESD diodes 105 does not change, causing relaxation oscillator 107 not to oscillate (fₜₑₛₜ = 0 Hz) such that the value of counter 111 does not increase.

Conversely, if the connection is faulty, relaxation oscillator 107 operates with a first oscillating at a frequency determined by R_{fb} and the total capacitance connected to its input, such that counter 111 registers a non-zero value. Then, in case of a ball break, when the value of counter 111 exceeds the value of threshold register 117, comparator 112 reports a connection failure.

As the inventors hereof have determined, the difference introduced by a ball-break failure is sufficient to make a reliable judgement of connection failure. Particularly, a typical setup may produce a difference of at least a factor of two in capacitive loading for relaxation oscillator 107. The oscillation frequency of relaxation oscillator 107 is one-to-one related to its capacitive loading, therefore the difference in oscillation frequency also becomes greater by at least a factor of two, which makes it detectable without false positives or negatives.

It is also worth noting that the amount of capacitance in a broken solder ball joint is smaller than the capacitance added by off-chip, external circuitry 200A/B. For example, if a solder ball has a diameter of 350 µm and we model a "broken ball" as a 5 µm air gap (i.e., a crack), the different in capacitive loading is approximately 170 fF, which is much less than minimal expected off-chip capacitance (> 1 pF).

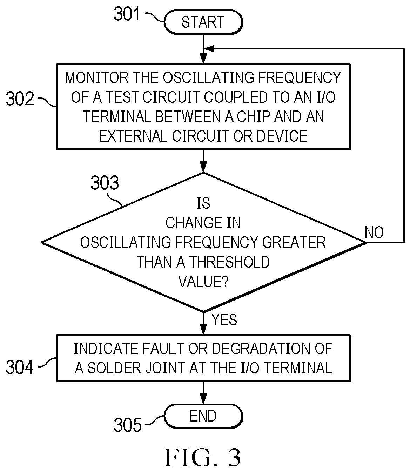

FIG. 3 is a flowchart of an example of method 300 for testing electrical connections between a chip and an external circuit. In various embodiments, method 300 may be performed, at least in part, by chip 100 when coupled (or when expected to be coupled) to external circuits 200A/B.

Method 300 starts at 301. At 302, method 300 monitors an oscillating frequency of test circuit 106 coupled to the S pad (e.g., via a solder joint) at the connection between chip 100 and external circuit 200A/B. For example, counter 111 may store the number of times Schmitt trigger 110 switches its output level for a certain time window, which is indicative of the then-present oscillation frequency of relaxation oscillator 107.

At 303, method 300 determines, through the operation of comparator 118, if there has been a change in the oscillating frequency greater than a threshold value stored in register 117 (e.g., for the same window duration). If not, at 303 control returns to 302, so that monitoring may continue while chip 100 is powered on.

Otherwise, at 304, the output of comparator 118 indicates an error representative of a fault, defect, error, or degradation of the solder joint at the connection between chip 100 and external circuits 200A/B. As shown, method 300 ends at 305.

In some implementations, method 300 may be performed for multiple pins, pads, or terminals on package 102 during operation of chip 100 and/or as part of a test procedure or event. Each time a fault is detected, method 300 may also identify which pin, pad, or terminal is defective depending upon which of a plurality of test circuits indicates it. Alternatively, when a single test circuit is shared across multiple pins, pads, or terminals, the state of a multiplexer between the test circuit and the pins, pads, or terminals may indicate which pin, pad, or terminal has a defect.

As such, various systems and methods for testing electrical connections between a chip and external circuitry have been presented. In an illustrative, non-limiting embodiment, a chip may include an Input/Output (I/O) terminal and a test circuit coupled to the I/O terminal, wherein an oscillating frequency of the test circuit changes in response to an impedance change at the I/O terminal due to a connection failure or degradation.

In some implementations, the chip may include an RF transceiver coupled to the I/O terminal. The IC may be manufactured on a die encapsulated by a package, and the I/O terminal may be external to the package. The I/O terminal may be coupled to a device disposed external to the chip. The device may include an antenna. Additionally, or alternatively, the device may include another chip.

A resonance frequency of the test circuit may be selected based, at least in part, upon an impedance at the I/O terminal in the absence of the connection failure or degradation. For example, the connection failure or degradation may include a breakage or fracture of a solder joint.

The test circuit may include a relaxation oscillator. The relaxation oscillator may include a Schmitt trigger and a feedback resistor. The chip may include a counter coupled to an output of the Schmitt trigger, where the counter is configured to store a value indicative of a frequency of oscillation of the test circuit.

The chip may include a comparator coupled to the counter and to a register configured to store a threshold value below which an increase in the frequency of oscillation indicates the connection failure or degradation.

In the absence of the connection failure or degradation, the relaxation oscillator does not oscillate when an antenna coupled to the I/O terminal behaves as a DC short between an S-pad and a G-pad. Moreover, in the absence of the connection failure or degradation, the frequency of oscillation is smaller than a frequency of operation of a main application of the chip.

In another illustrative, non-limiting embodiment, a test circuit, may a Schmitt trigger and a feedback resistor coupled across an input and an output of the Schmitt trigger, where the input of the Schmitt trigger is coupled to an electrical pad of a chip, and where the test circuit is configured to oscillate with a frequency indicative of a connection integrity between the chip and an external device coupled to the electrical pad.

The test circuit may have a resonance frequency selected based, at least in part, upon an impedance at the I/O terminal in the absence of fault or degradation of a solder joint at the electrical pad. In response to the connection being intact, the test circuit may not oscillate when an antenna coupled to the I/O terminal behaves as a DC short between an S-pad and a G-pad.

In yet another illustrative, non-limiting embodiment, a method may include: monitoring an oscillating frequency of a test circuit coupled to a connection between a chip and an antenna; and in response to a change in the oscillating frequency greater than a threshold value, identifying fault or degradation of a solder joint at the connection.

The oscillating frequency may change in response to a change in a parasitic capacitance. Also, an increase in the oscillating frequency may indicate reduced connection integrity.

In many implementations, systems and methods described herein may be incorporated into a wide range of electronic devices including, for example, computer systems or Information Technology (IT) products such as servers, desktops, laptops, memories, switches, routers, etc.; telecommunications hardware; consumer devices or appliances such as mobile phones, tablets, wearable devices, Internet-of-Things (IoT) devices, television sets, cameras, sound systems, etc.; scientific instrumentation; industrial robotics; medical or laboratory electronics such as imaging, diagnostic, or therapeutic equipment, etc.; transportation vehicles such as automobiles, buses, trucks, trains, watercraft, aircraft, etc.; military equipment, etc. More generally, these systems and methods may be incorporated into any device or system having one or more electronic parts or components.

For sake of brevity, conventional techniques have not been described in detail herein. Furthermore, the connecting lines shown in the various figures contained herein have been intended to illustrate relationships (e.g., logical) or physical couplings (e.g., electrical) between the various elements. It should be noted, however, that alternative relationships and connections may be used in other embodiments. Moreover, circuitry described herein may be implemented either in silicon or another semiconductor material or alternatively by software code representation thereof.

Although the invention(s) are described herein with reference to specific embodiments, various modifications and changes may be made without departing from the scope of the present invention(s), as set forth in the claims below. Accordingly, the specification and figures are to be regarded in an illustrative rather than a restrictive sense, and all such modifications are intended to be included within the scope of the present invention(s). Any benefits, advantages, or solutions to problems that are described herein with regard to specific embodiments are not intended to be construed as a critical, required, or essential feature or element of any or all the claims.

Reference is made herein to "configuring" a device or a device "configured to" perform some operation(s). It should be understood that this may include selecting predefined logic blocks and logically associating them. It may also include programming computer software-based logic of a retrofit control device, wiring discrete hardware components, or a combination of thereof. Such configured devices are physically designed to perform the specified operation(s).

Unless stated otherwise, terms such as "first" and "second" are used to arbitrarily distinguish between the elements such terms describe. Thus, these terms are not necessarily intended to indicate temporal or other prioritization of such elements. The terms "coupled" or "operably coupled" are defined as connected, although not necessarily directly, and not necessarily mechanically. The terms "a" and "an" are defined as one or more unless stated otherwise. The terms "comprise" (and any form of comprise, such as "comprises" and "comprising"), "have" (and any form of have, such as "has" and "having"), "include" (and any form of include, such as "includes" and "including") and "contain" (and any form of contain, such as "contains" and "containing") are open-ended linking verbs. As a result, a system, device, or apparatus that "comprises," "has," "includes" or "contains" one or more elements possesses those one or more elements but is not limited to possessing only those one or more elements. Similarly, a method or process that "comprises," "has," "includes" or "contains" one or more operations possesses those one or more operations but is not limited to possessing only those one or more operations.

## Claims

1. A chip (100), comprising:
an integrated circuit, IC, (104) manufactured on a die (101);
a package (102) encapsulating the die (101);
the chip (100) comprising an Input/Output, I/O, terminal (S) external to the package (102), for coupling to an external device (200A, 200B); and
a test circuit (106) coupled to the I/O terminal,
wherein an oscillating frequency of the test circuit (106) changes in response to an impedance change at the I/O terminal due to a connection failure or degradation of a connection between the external device and the I/O terminal.

2. The chip (100) of claim 1, wherein the chip (100) comprises a Radio Frequency, RF, transceiver coupled to the I/O terminal.

3. The chip (100) of claim1 or 2, wherein the device (200A; 200B) comprises an antenna (201A; 201B).

4. The chip (100) of any of claims 1 to 3, wherein the device (200A; 200B) comprises another chip.

5. The chip (100) of any of claims 1 to 4, wherein a resonance frequency of the test circuit (106) is selected based, at least in part, upon an impedance at the I/O terminal in the absence of the connection failure or degradation.

6. The chip (100) of claim 5, wherein the connection failure or degradation comprises a breakage or fracture of a solder joint.

7. The chip (100) of any of claims 1 to 6, wherein the test circuit (106) comprises a relaxation oscillator (107).

8. The chip (100) of claim 7, wherein the relaxation oscillator (107) comprises a Schmitt trigger (110) and a feedback resistor (108).

9. The chip (100) of any of claims 1 to 8, further comprising a counter (111) coupled to an output of the Schmitt trigger (110), wherein the counter (111) is configured to store a value indicative of a frequency of oscillation of the test circuit (106).

10. The chip (100) of claim 9, further comprising a comparator (112) coupled to the counter (111) and to a register (113) configured to store a threshold value below which an increase in the frequency of oscillation indicates the connection failure or degradation.

11. The chip (100) of claim 9 or 10, wherein in the absence of the connection failure or degradation, the relaxation oscillator (107) does not oscillate when an antenna coupled to the I/O terminal behaves as a DC short between an signal-pad (S) and a ground-pad (G).

12. The chip (100) of any of claims 9 to 11, wherein in the absence of the connection failure or degradation, the frequency of oscillation is smaller than a frequency of operation of a main application of the chip (100).

13. A method, comprising:
monitoring an oscillating frequency of a test circuit (106) coupled to a connection between a chip (100) and a device (200A, 200B) disposed external to the chip (100) by means of an Input/Output, I/O, terminal disposed external to a package (102) of the chip (100);
wherein the I/O terminal is coupled to a device (200A, 200B) disposed external to the chip (100); and
in response to a change in the oscillating frequency greater than a threshold value, the change resulting from an impedance change at the I/O terminal,
identifying fault or degradation of a solder joint at the connection.

## Patentansprüche

1. Chip (100), der Folgendes umfasst:
eine integrierte Schaltung, IC, (104), die auf einem Die (101) hergestellt ist;
ein Gehäuse (102), das den Die (101) verkapselt;
wobei der Chip (100) einen Eingabe/Ausgabe-, E/A-, Anschluss (S) außerhalb des Gehäuses (102) zum Koppeln mit einer externen Vorrichtung (200A, 200B) umfasst; und
eine Testschaltung (106), die mit dem E/A-Anschluss gekoppelt ist,
wobei sich eine oszillierende Frequenz der Testschaltung (106) als Reaktion auf eine Impedanzänderung an dem E/A-Anschluss aufgrund eines Verbindungsausfalls oder einer Verschlechterung einer Verbindung zwischen der externen Vorrichtung und dem E/A-Anschluss ändert.

2. Chip (100) nach Anspruch 1, wobei der Chip (100) einen Hochfrequenz-, HF-, Sendeempfänger umfasst, der mit dem E/A-Anschluss gekoppelt ist.

3. Chip (100) nach Anspruch 1 oder 2, wobei die Vorrichtung (200A; 200B) eine Antenne (201A; 201B) umfasst.

4. Chip (100) nach einem der Ansprüche 1 bis 3, wobei die Vorrichtung (200A; 200B) einen anderen Chip umfasst.

5. Chip (100) nach einem der Ansprüche 1 bis 4, wobei eine Resonanzfrequenz der Testschaltung (106) zumindest teilweise basierend auf einer Impedanz an dem E/A-Anschluss in Abwesenheit des Verbindungsausfalls oder der Verschlechterung ausgewählt wird.

6. Chip (100) nach Anspruch 5, wobei der Verbindungsausfall oder die Verschlechterung einen Bruch oder Riss einer Lötverbindung umfasst.

7. Chip (100) nach einem der Ansprüche 1 bis 6, wobei die Testschaltung (106) einen Relaxationsoszillator (107) umfasst.

8. Chip (100) nach Anspruch 7, wobei der Relaxationsoszillator (107) einen Schmitt-Trigger (110) und einen Rückkopplungswiderstand (108) umfasst.

9. Chip (100) nach einem der Ansprüche 1 bis 8, der ferner einen Zähler (111) umfasst, der mit einem Ausgang des Schmitt-Triggers (110) gekoppelt ist, wobei der Zähler (111) dazu ausgelegt ist, einen Wert zu speichern, der eine Oszillationsfrequenz der Testschaltung (106) angibt.

10. Chip (100) nach Anspruch 9, der ferner einen Komparator (112) umfasst, der mit dem Zähler (111) und mit einem Register (113) gekoppelt ist, das dazu ausgelegt ist, einen Schwellenwert zu speichern, unter dem eine Erhöhung der Oszillationsfrequenz den Verbindungsausfall oder die Verschlechterung angibt.

11. Chip (100) nach Anspruch 9 oder 10, wobei in Abwesenheit des Verbindungsausfalls oder der Verschlechterung der Relaxationsoszillator (107) nicht oszilliert, wenn sich eine mit dem E/A-Anschluss gekoppelte Antenne wie ein DC-Kurzschluss zwischen einem Signalpad (S) und einem Massepad (G) verhält.

12. Chip (100) nach einem der Ansprüche 9 bis 11, wobei in Abwesenheit des Verbindungsausfalls oder der Verschlechterung die Oszillationsfrequenz kleiner als eine Betriebsfrequenz einer Hauptanwendung des Chips (100) ist.

13. Verfahren, das Folgendes umfasst:
Überwachen einer oszillierenden Frequenz einer Testschaltung (106), die mit einer Verbindung zwischen einem Chip (100) und einer Vorrichtung (200A, 200B) gekoppelt ist, die außerhalb des Chips (100) angeordnet ist, mittels eines Eingabe/Ausgabe-, E/A-, Anschlusses, der außerhalb eines Gehäuses (102) des Chips (100) angeordnet ist;
wobei der E/A-Anschluss mit einer Vorrichtung (200A, 200B) gekoppelt ist, die außerhalb des Chips (100) angeordnet ist; und
als Reaktion auf eine Änderung der oszillierenden Frequenz, die größer als ein Schwellenwert ist, wobei die Änderung aus einer Impedanzänderung an dem E/A-Anschluss resultiert,
Identifizieren eines Fehlers oder einer Verschlechterung einer Lötverbindung an der Verbindung.

## Revendications

1. Puce (100), comprenant :
un circuit intégré, CI, (104) fabriqué sur un dé (101) ;
un boîtier (102) renfermant le dé (101) ;
la puce (100) comprenant une borne d'entrée/sortie E/S (S) externe au boîtier (102), pour un couplage à un dispositif externe (200A, 200B) ; et
un circuit de test (106) couplé à la borne E/S,
dans laquelle une fréquence d'oscillation du circuit de test (106) change en réponse à un changement d'impédance au niveau de la borne E/S en raison d'une défaillance ou d'une dégradation de connexion d'une connexion entre le dispositif externe et la borne E/S.

2. Puce (100) selon la revendication 1, dans laquelle la puce (100) comprend un émetteur-récepteur radiofréquence, RF, couplé à la borne E/S.

3. Puce (100) selon la revendication 1 ou 2, dans laquelle le dispositif (200A ; 200B) comprend une antenne (201A ; 201B).

4. Puce (100) selon l'une quelconque des revendications 1 à 3, dans laquelle le dispositif (200A ; 200B) comprend une autre puce.

5. Puce (100) selon l'une quelconque des revendications 1 à 4, dans laquelle une fréquence de résonance du circuit de test (106) est sélectionnée sur la base, au moins en partie, d'une impédance au niveau de la borne E/S en l'absence de défaillance ou de dégradation de connexion.

6. Puce (100) selon la revendication 5, dans laquelle la défaillance ou la dégradation de connexion comprend une rupture ou une cassure d'un joint de soudure.

7. Puce (100) selon l'une quelconque des revendications 1 à 6, dans laquelle le circuit de test (106) comprend un oscillateur à relaxation (107).

8. Puce (100) selon la revendication 7, dans laquelle l'oscillateur à relaxation (107) comprend une bascule de Schmitt (110) et une résistance de rétroaction (108).

9. Puce (100) selon l'une quelconque des revendications 1 à 8, comprenant en outre un compteur (111) couplé à une sortie de la bascule de Schmitt (110), le compteur (111) étant configuré pour stocker une valeur indiquant une fréquence d'oscillation du circuit de test (106).

10. Puce (100) selon la revendication 9, comprenant en outre un comparateur (112) couplé au compteur (111) et à un registre (113) configuré pour stocker une valeur de seuil en dessous de laquelle une augmentation de la fréquence d'oscillation indique la défaillance ou la dégradation de connexion.

11. Puce (100) selon la revendication 9 ou 10, dans laquelle, en l'absence de défaillance ou de dégradation de connexion, l'oscillateur à relaxation (107) n'oscille pas lorsqu'une antenne couplée à la borne E/S se comporte comme un court-circuit CC entre un plot de signal (S) et un plot de terre (G).

12. Puce (100) selon l'une quelconque des revendications 9 à 11, dans laquelle, en l'absence de défaillance ou de dégradation de connexion, la fréquence d'oscillation est inférieure à une fréquence de fonctionnement d'une application principale de la puce (100).

13. Procédé, comprenant :
la surveillance d'une fréquence d'oscillation d'un circuit de test (106) couplé à une connexion entre une puce (100) et un dispositif (200A, 200B) disposé à l'extérieur de la puce (100) au moyen d'une borne d'entrée/sortie, E/S, disposée à l'extérieur d'un boîtier (102) de la puce (100) ;
dans lequel la borne E/S est couplée à un dispositif (200A, 200B) disposé à l'extérieur de la puce (100) ; et
en réponse à un changement de la fréquence d'oscillation supérieur à une valeur seuil, le changement résultant d'un changement d'impédance au niveau de la borne E/S,
l'identification d'un défaut ou d'une dégradation d'un joint de soudure au niveau de la connexion.
